# EUROPÄISCHE PATENTANMELDUNG

(11) **EP 1 599 078 A2**
(43) Veröffentlichungstag der Anmeldung: **23.11.2005**
(21) Anmeldenummer: 05004621.8
(22) Anmeldetag: 03.03.2005
(51) Int. Cl.: H05K 3/34, B23K 3/06, B23K 35/02, H01L 21/68, H01L 21/60

(54) **Verfahren zur Befestigung von elektronischen Bauelementen auf einem Substrat**

(30) Priorität: 22.04.2004 DE 102004019567; 24.11.2004 DE 102004056702
(71) Anmelder: Semikron Elektronik GmbH & Co. KG Patentabteilung, 90431 Nürnberg (DE)
(72) Erfinder: Palm, Gerhard, 38173 Sickte (DE)

(57) **Zusammenfassung**

Die Erfindung beschreibt zwei Verfahren zur Befestigung von elektronischen Bauelementen, insbesondere von Leistungshalbleiterbauelementen wie Dioden, Transistoren oder Thyristoren, und von Anschlusselementen mittels Drucksintern mit den Verfahrensschritten des ersten Verfahrens: Aufbringen einer aus einem Metallpulver und einem Lösungsmittel bestehenden pastösen Schicht (20) auf eine Trägerfolie (10); Trocknen der pastösen Schicht; Aufbringen von mindestens einem Bauelement (40) auf die getrocknete Schicht; Druckbeaufschlagung des Verbunds aus dem mindestens einen Bauelement und der Trägerfolie mit der getrockneten Schicht, wodurch die Haftkraft zwischen der Schicht (20) und dem Bauelement (40) größer wird als zwischen der Schicht (20) und der Trägerfolie (10); Abheben des mindestens einen Bauelements (40) mit daran haftender Schicht (20") von der Trägerfolie (10); Positionierung des Bauelements (40) mit der daran haftenden Schicht (20") auf dem Substrat (50); Druckbeaufschlagung der Anordnung des Substrats (50) und des Bauelements (40) zu deren Sinterverbindung.

## Beschreibung

Die Erfindung beschreibt Verfahren zur Befestigung von elektronischen Bauelementen, insbesondere von Leistungshalbleiterbauelementen wie Dioden, Transistoren oder Thyristoren, auf einem Substrat, sowie von Anschlusselementen auf diesen Bauelementen oder dem Substrat. Bei den Verfahren handelt es sich um ein Sinterverfahren, wie es grundsätzlich bereits seit langem bekannt ist.

Den grundlegenden Stand der Technik hierzu bilden die DE 34 14 065 C2 sowie die EP 0 242 626 B1. Die DE 34 14 065 C2 offenbart ein Verfahren, das durch folgende wesentliche Verarbeitungsschritte gekennzeichnet ist:
- Aufbringen einer aus einem Metallpulver und einem Lösungsmittel bestehenden pastösen Schicht auf die zu verbindende Kontaktfläche des Bauelements oder des Substrats;
- Aufbringen des Bauelements auf das Substrat, wobei die pastöse Schicht zwischen dem Bauelement und dem Substrat angeordnet wird;
- Austreiben des Lösungsmittels aus dem Verbund aus Bauelement, pastöser Schicht und Substrat;
- Erwärmung des Verbunds auf Sintertemperatur, vorzugsweise unter zusätzlicher Druckbeaufschlagung.

Nachteilig am genannten Stand der Technik ist, dass der Trockenvorgang der pastösen Schicht nach dem Zusammenfügen des Bauelements und des Substrats durchgeführt wird. Da hier ein schnelles Ausgasen über eine große Oberfläche nicht möglich ist, ist dieses Verfahren durch erhebliche Prozesszeiten gekennzeichnet. Die EP 0 242 626 B1 offenbart demgegenüber ein Verfahren, das durch folgende wesentliche Verarbeitungsschritte gekennzeichnet ist:
- Aufbringen einer aus einem Metallpulver und einem Lösungsmittel bestehenden pastösen Schicht auf die zu verbindende Kontaktfläche des Bauelements oder des Substrats;
- Trocknen der pastösen Schicht;
- Aufbringen des Bauelements auf das Substrat, wobei die getrocknete pastöse Schicht zwischen dem Bauelement und dem Substrat angeordnet wird;
- Erwärmung des Verbunds auf Sintertemperatur unter zusätzlicher Druckbeaufschlagung.

Dieses Verfahren vermeidet den Hauptnachteil des erstgenannten Stands der Technik. Allerdings weist dieses Verfahren, wie auch das erstgenannte den Nachteil auf, dass es sich um ein rein serielles Verfahren handelt, das einer modernen und rationellen Fertigung derartiger Verbindungen entgegen steht.

Ebenso nachteilig an den genannten Verfahren ist, dass ein strukturiertes Aufbringen der pastösen Schicht auf das Bauelement oder das Substrat nur unter erheblichem Aufwand möglich ist.

Die vorliegende Erfindung hat die Aufgabe ein Verfahren zur Befestigung von elektronischen Bauelementen auf einem Substrat und eines zur Befestigung von Anschlusselementen mittels Drucksintern vorzustellen, welches einer rationellen und zumindest teilweise parallelen Verarbeitung einer Mehrzahl von Bauelementen zugänglich ist sowie eine strukturierte Ausgestaltung der Sinterschicht erlaubt.

Die Aufgabe wird gelöst durch Verfahren mit den Merkmalen der Ansprüche 1 und 2. Bevorzugte Weiterbildungen finden sich in den Unteransprüchen.

Die erfindungsgemäßen Verfahren zur Befestigung von elektronischen Bauelementen, wobei die Bauelemente insbesondere als Leistungshalbleiterbauelementen wie Dioden, Transistoren oder Thyristoren ausgebildet sind, auf einem Substrat und zur Befestigung von Anschlusselementen mittels Drucksintern sind gekennzeichnet durch unten genannte wesentliche Verfahrensschritte. Erstes Verfahren zur Befestigung von Bauelementen:
a) Aufbringen einer pastösen Schicht auf eine Trägerfolie. Hierbei besteht diese Schicht gemäß dem Stand der Technik aus einem Gemisch aus einem Metallpulver und einem Lösungsmittel.
b) Trocknen der pastösen Schicht.
c) Aufbringen von mindestens einem, vorteilhafterweise einer Mehrzahl von Bauelementen auf die getrocknete Schicht. Hierbei sind die Bauelemente vorzugsweise auf einer über einem Rahmen aufgespannten Trägerfolie angeordnet.
d) Druckbeaufschlagung des Verbunds aus dem mindestens einem Bauelement und der Trägerfolie mit der getrockneten Schicht. Hierdurch wird die Haftkraft zwischen der Schicht und dem Bauelement größer als die Haftkraft zwischen der Schicht und der Trägerfolie.
e) Abheben des mindestens einen Bauelements mit daran haftender Schicht von der Trägerfolie.
f) Positionierung des mindestens einen Bauelements mit der daran haftenden Schicht auf dem Substrat.
g) Druckbeaufschlagung der Anordnung des Substrats und des mindestens einen Bauelements, wodurch die Sinterverbindung entsteht.

Für einen nicht homogenen Auftrag der pastösen Schicht auf das Bauelement wird vor dem Prozessschritt (a) die Trägerfolie entsprechend strukturiert. Hierzu werden mit bekannten Techniken Ausnehmungen in die Folie eingebracht. Beim Aufbringen der Schicht wird diese somit ohne weiteren Aufwand direkt strukturiert. Diese Struktur wird anschließend im Prozessschritt (c) ebenso einfach auf die Bauelemente übertragen.

Zweites Verfahren zur Befestigung von Anschlusselementen, wobei dieses Verfahren auch als Alternativverfahren in analoger Weises auf Bauelemente angewendete werden kann:
a) Aufbringen einer pastösen Schicht auf eine erste, bereits strukturierte, Trägerfolie. Hierbei besteht diese Schicht ebenfalls aus dem Gemisch aus einem Metallpulver und einem Lösungsmittel.
b) Trocknen der pastösen Schicht.
c) Aufbringen einer zweite gegenüber der ersten dünner ausgestalteten Folie auf die getrocknete Schicht;
d) Druckbeaufschlagung des Verbunds aus der ersten Trägerfolie und der zweiten Folie mit der getrockneten Schicht, wodurch die Haftkraft zwischen der Schicht und der zweiten Folie größer wird als zwischen der Schicht und der Trägerfolie;
e) Abheben der zweiten Folie mit daran haftender Schicht von der Trägerfolie;
f) Positionierung von vereinzelten Metallplättchen, gebildet aus der getrockneten Schicht, auf einem Bauelement oder auf dem Substrat;
g) Druckbeaufschlagung der Anordnung aus Substrat, Bauelement und Anschlusselement oder der Anordnung aus Substrat und Anschlusselement zu deren jeweiliger Sinterverbindung.

Nachfolgend wird der erfinderische Gedanke der beiden Verfahren anhand der Fig. 1 bis 8 beispielhaft erläutert.

Fig. 1 zeigt den Verfahrensschritt (a) des ersten erfindungsgemäßen Verfahrens.

Fig. 2 zeigt den Verfahrensschritt (d) des ersten erfindungsgemäßen Verfahrens.

Fig. 3 zeigt die Verfahrensschritte (e, f) des ersten erfindungsgemäßen Verfahrens.

Fig. 4 zeigt den Verfahrensschritt (g) des ersten erfindungsgemäßen Verfahrens.

Fig. 5 zeigt den Verfahrensschritt (a) des zweiten erfindungsgemäßen Verfahrens.

Fig. 6 zeigt den Verfahrensschritt (d) des zweiten erfindungsgemäßen Verfahrens.

Fig. 7 zeigt den Verfahrensschritt (e) des zweiten erfindungsgemäßen Verfahrens.

Fig. 8 zeigt den Verfahrensschritt (g) des zweiten erfindungsgemäßen Verfahrens.

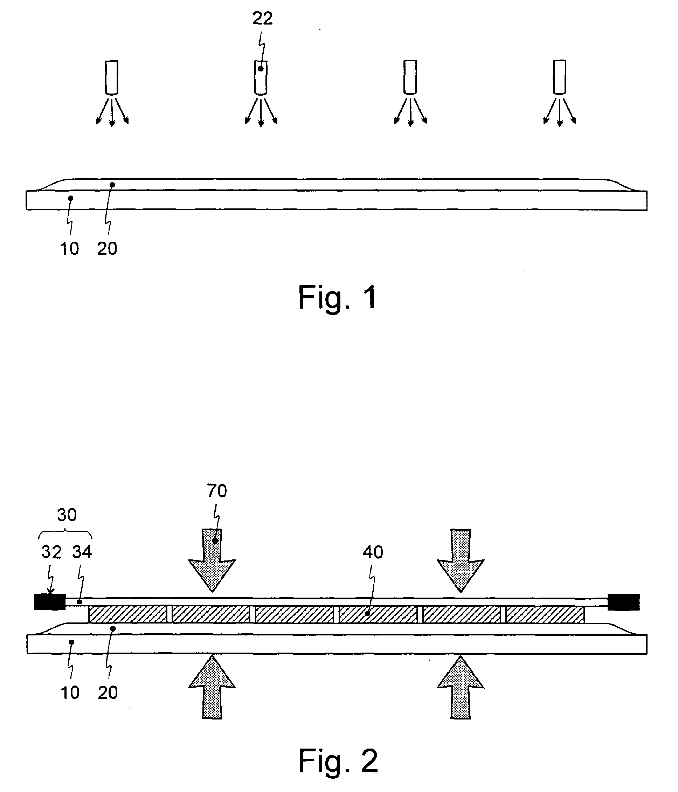

Fig. 1 zeigt den Verfahrensschritt (a) des ersten erfindungsgemäßen Verfahrens. Die Basis bildet eine Trägerfolie (10), vorzugsweise eine Polyesterfolie mit einer Dicke zwischen 100µm und 200µm. Hierauf wird mittels eines Sprühverfahrens (22) eine pastöse Schicht (20) aufgebracht. Ebenso anwendbar sind andere nach dem Stand der Technik bekannte Verfahren, wie beispielsweise ein Siebdruckverfahren. Die pastöse Schicht besteht (20) aus einer Mischung eines Metallpulvers, vorzugsweise aus Silber oder einer Silberlegierung, mit Cyclohexanol im Verhältnis von 1:2 bis 1:4. Die Schichtdicke dieser Schicht beträgt zwischen 10µm und 50µm.

Um Bauelemente nicht flächig, sondern strukuriert zu beschichten, wie es beispielhaft für Steueranschlüsse notwendig sein kann, wird die Trägerfolie (10) vor der Beschichtung in sich strukturiert.

In einem weiteren Verfahrensschritt (b) wird die aufgebrachte pastöse Schicht (20) bei einer Temperatur zwischen 100°C und 200°C getrocknet.

Anschließend werden die Bauelemente (40) im Verfahrensschritt (c) auf die nun getrocknete Schicht (20') aufgebracht. Hierbei sind die Bauelemente (40) nach dem Stand der Technik auf einer in einen Rahmen (32) gespannten Folie (34) angeordnet. Diese Anordnung der Bauelemente (40) erfordert keinen zusätzlicher Arbeitsschritt, da der letzte Fertigungsschritt der Herstellung von Halbleiterbauelementen das Sägen der im Waferverbund vorhandenen Bauelemente ist und hierzu die Bauelemente (40) auf derartige Trägervorrichtungen (30) aufgebracht werden. Somit werden die Bauelemente (40) auf dieser Vorrichtung (30) belassen, wie es auch für andere nach dem Stand der Technik bekannte Verarbeitungsschritte von ungehausten Bauelementen üblich ist.

Fig. 2 zeigt den Verfahrensschritt (d) des ersten erfindungsgemäßen Verfahrens. Hierbei wird der Verbund aus Trägerfolie (10), getrockneter Schicht (20') und Bauelementen (40) mit Druck beaufschlagt. Als vorteilhaft hat sich hierbei ein Druck (70) zwischen 20 MPa und 80 MPa und eine Temperatur zwischen 40°C und 100°C erwiesen. Der hierbei eingeleitete Druck ist ausreichend um eine Verbindung zwischen dem Bauelement (40) und der getrockneten Schicht (20') herzustellen, die eine höhere Haftkraft aufweist als die Verbindung zwischen der Trägerfolie (10) und dem Bauelement (40).

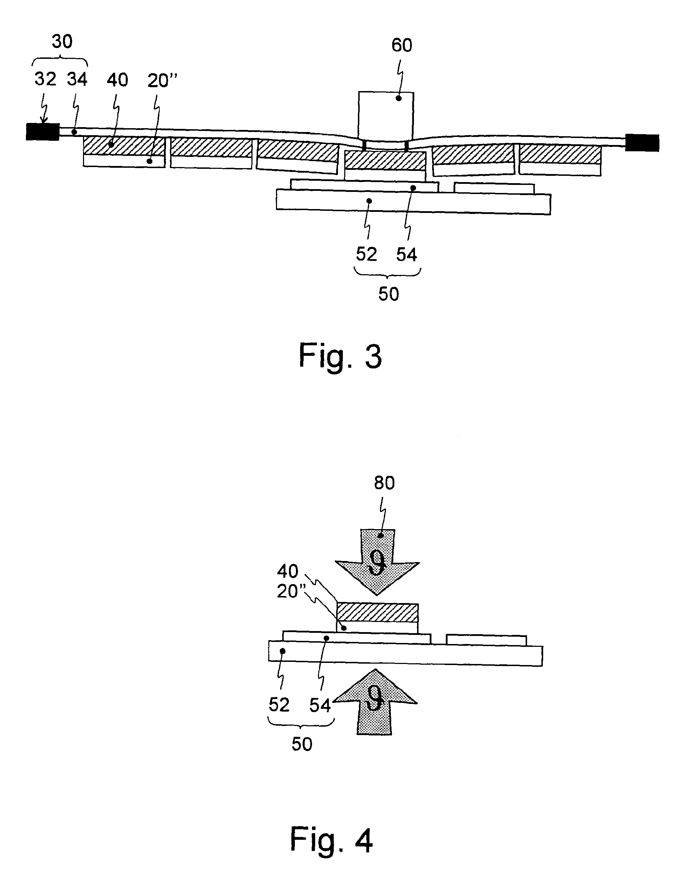

In einem weiteren Verfahrensschritt (e) werden die beschichteten Bauelemente (40, 20") aus dem Verbund gelöst und an denjenigen Stellen eine Substrats (50) angeordnet, an denen die Verbindung zwischen den Bauelementen (40) und dem Substrat (50) hergestellt werden soll. Hierbei können Abnahmevorrichtungen (60), wie sie aus so genannten "Pickand- Place- Automaten" der Halbleiterbauelementverarbeitung bekannt sind, verwendet werden. Fig. 3 zeigt für den Verfahrensschritt (f) eine derartige Vorrichtung (60). Hierbei drückt ein Stempel (60), der mit einem Nadelsystem ausgestattet ist, von der dem Bauelement (40) abgewandten Seite auf die Trägerfolie (34) der Vorrichtung (30). Hiermit wird das Bauelement (40) zumindest von der Trägerfolie (34) abgehoben. Vollständig getrennt wird das Bauelement (40) durch das Nadelsystem, das die Folie (32) durchsticht. Somit können mit bekannten Techniken einzelne Bauelement (40) beliebig auf einer Leiterbahn (52) des Substrats (50) positioniert werden.

In einem abschließenden Verfahrenschritt (g) wird die Anordnung aus Bauelement (40) mit abgeschiedener Schicht (20") und Substrat (50) mit Druck von mehr als 30 MPa beaufschlagt. Bei gleichzeitiger Erwärmung (ϑ) auf Werte von mehr als 220°C wird die Sinterverbindung hergestellt.

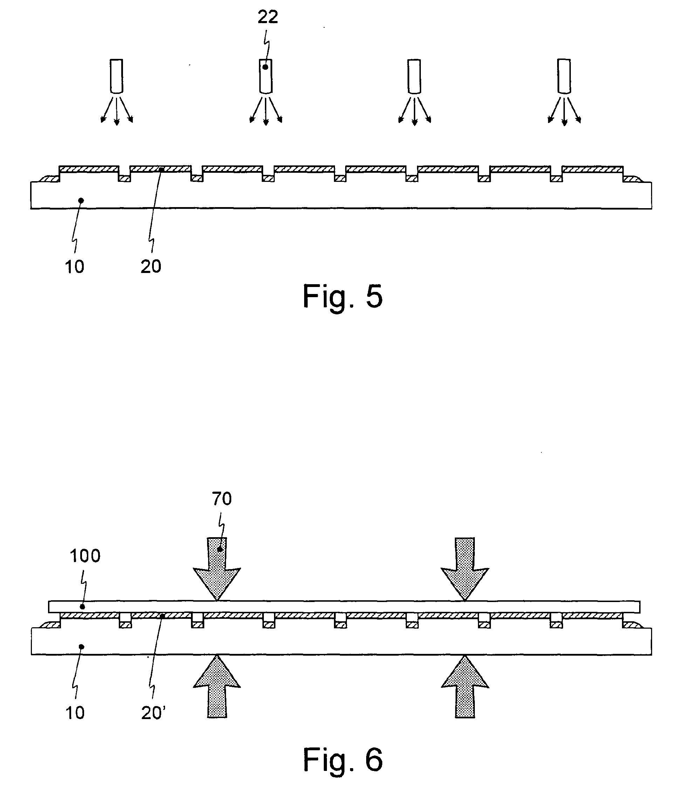

Fig. 5 zeigt den Verfahrensschritt (a) des zweiten erfindungsgemäßen Verfahrens. Die Basis bildet wiederum die Trägerfolie (10). Vorteilhafterweise wurde diese Folie vor dem Verfahrensschritt (a) bereits strukturiert, wofür sich beispielhaft ein Prägeverfahren eignet. Auf diese Trägerfolie (10) wird mittels des Sprühverfahrens (22) die pastöse Schicht (20) aufgebracht.

Die Strukturierung der Trägerfolie dient dazu gleichzeitig mit dem Verfahrensschritt des Beschichtens mehrere flächige Bereiche der Metallpulverschicht in einem Verfahrensschritt frei zu stellen. Somit ergeben sich bereits in diesem Verfahrensschritt einzelne beliebig geformte flächige Bereiche. Altemativ kann das Freistellen einzelner Bereiche erst in einem späteren Verfahrensschritt, beispielhaft anschließend an den Verfahrensschritt (d) erfolgen.

In einem weiteren Verfahrensschritt (b) wird die aufgebrachte pastöse Schicht (20) wiederum bei einer Temperatur zwischen 100°C und 200°C getrocknet.

Fig. 6 zeigt den Verfahrensschritt (d) des zweiten erfindungsgemäßen Verfahrens. Hierbei wurde vorher im Verfahrensschritt (c) auf die getrocknete Schicht (20') eine zweite Folie (100) aufgebracht. Diese zweite Folie (100) weist im vergleich zur ersten Trägerfolie (10) eine geringere Dicke im Bereich zwischen 10µm und 100µm auf. Anschließend wird im Verfahrensschritt (d) der Verbund aus Trägerfolie (10), getrockneter Schicht (20') und zweiter Folie (100) mit Druck beaufschlagt. Als vorteilhaft hat sich hierbei ein Druck (70) zwischen 20 MPa und 80 MPa und eine Temperatur zwischen 40°C und 100°C erwiesen. Der hierbei eingeleitete Druck ist ausreichend um eine Verbindung zwischen der zweiten Folie (100) und der getrockneten Schicht (20') herzustellen, die eine höhere Haftkraft aufweist als die Verbindung zwischen der Trägerfolie (10) und der getrockneten Schicht (20').

In einem weiteren Verfahrensschritt (e) wird die zweite Folie (100) mit daran anhaftender getrockneter Schicht (20') von der ersten Trägerfolie (10) abgehoben. Falls die erste Trägerfolie (10) bereits strukturiert war haften nun einzelne Metallplättchen (22) an der zweiten Trägerfolie (100). Falls die erste Trägerfolie (10) nicht strukturiert war wird dies nun in einen Zwischenschritt des Verfahrens ausgeführt.

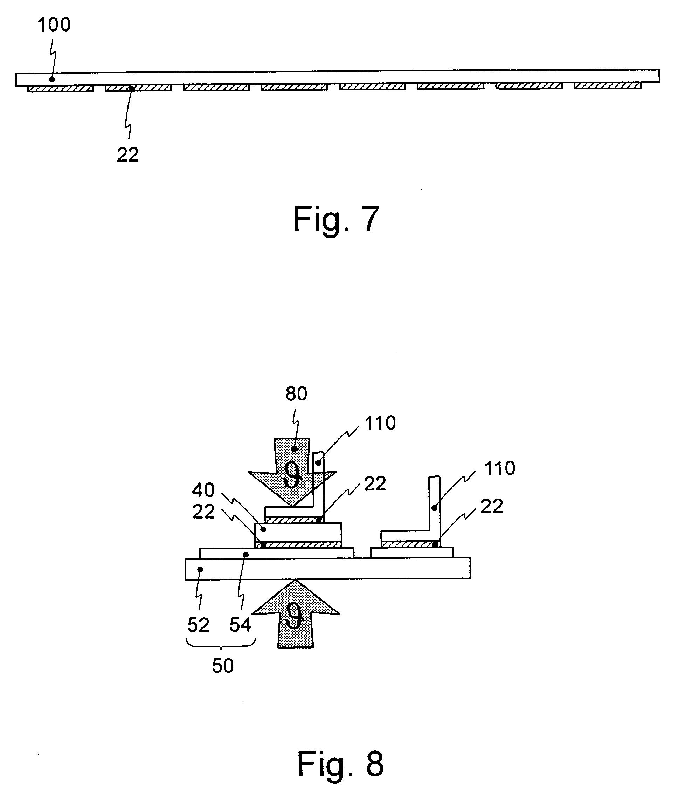

Fig. 7 zeigt die zweite Folie (100) mit daran anhaftenden beliebig geformten Metallplättchen (22). Diese Metallplättchen (22) werden im nachfolgenden Verfahrensschritt (f) auf einem Bauelement oder dem Substrat angeordnet. Hierzu eignet sich ein oben genannter "Pick- and- Place- Automat".

Fig. 8 zeigt die Anordnung eines Bauelements auf einem Substrat (50) mit dazwischen angeordnetem Metallplättchen (22) gemäß Fig. 4. Auf diesem Bauelement wird nun wie oben beschrieben ein weiteres Metallplättchen (22) angeordnet und hierauf ein Anschlusselement (110). Dieses Anschlusselement (110) kann dem äußeren Anschluss des Bauelements (40) oder aber der Verbindung zu weiteren Bauelementen oder zu weiteren Kontaktflächen (54) des Substrats (50) dienen. Auf derartigen Kontaktflächen (54) des Substrats (50) sind ebenfalls Metallplättchen (22) angeordnet, auf denen wiederum Anschlusselemente (110) angeordnet sind. Diese dienen wie bereits beschrieben der Verbindung zu Bauelementen (40) oder auch der externen Verbindung.

In einem abschließenden Verfahrenschritt (g) wird die Anordnung aus Substrat (50), Metallplättchen (22), Bauelement (40), weiterem Metallplättchen (22) und Anschlusselement (110) mit Druck von mehr als 30 MPa beaufschlagt. Bei gleichzeitiger Erwärmung (ϑ) auf Werte von mehr als 220°C wird die Sinterverbindung hergestellt. Ebenso wird die Anordnung aus Substrat (50), Metallplättchen (22) und Anschlusselement (110) in gleicher Weise mit Druck und Temperatur beaufschlagt und hier ebenfalls die Sinterverbindung hergestellt.

## Patentansprüche

1. Verfahren zur Befestigung von elektronischen Bauelementen (40), insbesondere von Leistungshalbleiterbauelementen wie Dioden, Transistoren oder Thyristoren, auf einem Substrat (50) mittels Drucksintern mit den Verfahrensschritten:
a) Aufbringen einer aus einem Metallpulver und einem Lösungsmittel bestehenden pastösen Schicht (20) auf eine Trägerfolie (10);
b) Trocknen der pastösen Schicht (20);
c) Aufbringen von mindestens einem Bauelement (40) auf die getrocknete Schicht (20');
d) Druckbeaufschlagung (70) des Verbunds aus dem mindestens einen Bauelement (40) und der Trägerfolie (10) mit der getrockneten Schicht (20'), wodurch die Haftkraft zwischen der Schicht (20') und dem Bauelement (40) größer wird als zwischen der Schicht (20') und der Trägerfolie (10);
e) Abheben des mindestens einen Bauelements (40) mit daran haftender Schicht (20") von der Trägerfolie (10);
f) Positionierung des Bauelements (40) mit der daran haftenden Schicht (20") auf dem Substrat (50);
g) Druckbeaufschlagung (80) der Anordnung des Substrats (50) und des Bauelements (40) zu deren Sinterverbindung.

2. Verfahren zur Befestigung von elektronischen Bauelementen (40) auf einem Substrat (50) und / oder zur Befestigung von Anschlusselementen (110) auf elektronischen Bauelementen (40) oder einem Substrat (50) mittels Drucksintern mit den Verfahrensschritten:
a) Aufbringen einer aus einem Metallpulver und einem Lösungsmittel bestehenden pastösen Schicht (20) auf eine erste, strukturierte, Trägerfolie (10);
b) Trocknen der pastösen Schicht (20);
c) Aufbringen einer zweiten gegenüber der ersten Trägerfolie (10) dünner ausgestalteten Folie (100) auf die getrocknete Schicht (20');
d) Druckbeaufschlagung (70) des Verbunds aus der ersten Trägerfolie (10) mit der getrockneten Schicht (20') und der zweiten Folie (100), wodurch die Haftkraft zwischen der Schicht (20') und der zweiten Folie (100) größer wird als zwischen der Schicht (20') und der Trägerfolie (10);
e) Abheben der zweiten Folie (100) mit daran haftender Schicht (20") von der Trägerfolie (10);
f) Positionierung einzelner Metallplättchen (22) gebildet aus der getrockneten Schicht (20') auf einem Bauelement (40) oder auf dem Substrat (50);
g) Druckbeaufschlagung (80) der Anordnung aus Substrat (50), Bauelement (40) und Anschlusselement (110) oder der Anordnung aus Substrat (50) und Anschlusselements (110) mit jeweils dazwischen angeordneten Metallplättchen (22) zu deren jeweiliger Sinterverbindung.

3. Verfahren nach Anspruch 1 oder 2, wobei
die Trägerfolie (10) aus einen Polyesterfolie mit einer Dicke zwischen 100µm und 200µm besteht.

4. Verfahren nach Anspruch 1 oder 2, wobei
die Trägerfolie (10) in sich strukturiert ist um das Bauelement (40) strukturiert zu beschichten.

5. Verfahren nach Anspruch 1 oder 2, wobei
die pastöse Schicht (20) aus einer Mischung aus Silberpulver mit Cyclohexanol im Verhältnis von 1:2 bis 1:4 besteht und eine Schichtdicke zwischen 10µm und 50µm aufweist.

6. Verfahren nach Anspruch 1 oder 2, wobei
die pastöse Schicht (20) bei einer Temperatur zwischen 100°C und 200°C getrocknet wird.

7. Verfahren nach Anspruch 1, wobei
der Verbund aus Bauelement (40) und Trägerfolie (10) mit pastöser Schicht (20') für 5 bis 20 Sekunden mit einem Druck zwischen 20 MPa und 80 MPa und einer Temperatur zwischen 40°C und 100°C beaufschlagt wird.

8. Verfahren nach Anspruch 1, wobei
eine Mehrzahl von Bauelementen (40) mittels einer auf der der Schicht (20) abgewandten Seite mittels eines Trägers (30) bestehend aus einem Rahmen (32) und einer Haftfolie (34) zueinander angeordnet sind.

9. Verfahren nach Anspruch 2, wobei
die zweite Folie (100) aus einer Polyesterfolie mit einer Dicke zwischen 10µm und 100µm besteht.

10. Verfahren nach Anspruch 2, wobei
der Verbund aus erster Trägerfolie (10) mit pastöser Schicht (20') zweiter Folie (100) für 5 bis 20 Sekunden mit einem Druck zwischen 20 MPa und 80 MP a und einer Temperatur zwischen 40°C und 100°C beaufschlagt wird.
